# EUROPEAN PATENT SPECIFICATION

(11) **EP 4 083 491 B1**
(45) Date of publication and mention of the grant of the patent: **31.01.2024**
(21) Application number: 20913555.7
(22) Date of filing: 27.09.2020
(51) Int. Cl.: F16M 13/02, F16M 11/04

(54) **MULTI-PANEL WRAPAROUND STEREOSCPIC DISPLAY**
STEREOSCOPISCHE ANZEIGE MIT MEHREREN TAFELN
DISPOSITIF D'AFFICHAGE STÉRÉOSCOPIQUE ENVELOPPANT A PANNEAUX MULTIPLES

(30) Priority: 16.01.2020 CN 202010046565
(43) Date of publication of application: 02.11.2022
(73) Proprietor: Qingdao Zhisheng Media Equipment Co., Ltd., Shandong 266000 (CN)
(72) Inventor: WANG, Mingxun, Qingdao, Shandong 266000 (CN); ZHANG, Shenggang, Qingdao, Shandong 266000 (CN); ZHOU, Changsheng, Qingdao, Shandong 266000 (CN); WANG, Shengxun, Qingdao, Shandong 266000 (CN); MENG, Qingfu, Qingdao, Shandong 266000 (CN)
(74) Representative: Bayramoglu et al.
(86) International application number: PCT/CN2020/117983
(87) International publication number: WO 2021/143200

(56) References cited:
- EP-A1- 3 346 457
- CN-A- 103 511 813
- CN-A- 107 270 081
- CN-A- 107 725 996
- CN-A- 109 237 240
- CN-A- 111 076 066
- CN-U- 202 733 350
- CN-U- 210 955 908
- DE-U1- 29 606 267
- US-A1- 2011 309 041

## Description

### TECHNICAL FIELD

The present disclosure relates to the technical field of display, and in particular, to a multi-panel wraparound stereoscopic display.

### BACKGROUND

With the expansion of the application field of displays, airports, subways, and other places with large passenger flow are increasingly using displays to replace traditional advertising lamp boxes for advertisement. In the scenario of large passenger flow in places like airports, in order to improve the effectiveness of advertisements, displays are usually disposed at heights, and have a large size, see for example DE29606267U1.

However, a traditional display is connected through a hinge or a pneumatic rod, which occupies a large amount of space during maintenance and is inconvenient to install or maintain. Therefore, it is not suitable for high-altitude operations.

### SUMMARY

In order to resolve the problems in the prior art, the present disclosure provides a multi-panel wraparound stereoscopic display to meet the advertisement requirements of airports, subways, and other places, and realize the technical effect of convenient assembling, disassembling, and maintenance of the display. The present disclosure adopts the following technical solutions:
A multi-panel wraparound stereoscopic display includes a skeleton, a display screen, a mounting panel, and a hanger.

At least three display screens are detachably installed on the skeleton through as many hangers there are screens, multiple display screens are rotatably symmetrically distributed along an axis of symmetry, and the display screens are disposed in parallel with the axis of symmetry.

Every hanger includes a fixed plate, a rotating plate, and a connecting plate. A display screen is detachably installed on the connecting plate, and the fixed plate is detachably installed on the skeleton. The fixed plate and the connecting plate are respectively hinged to both ends of the rotating plate to form a double rocker mechanism, and the rotating plate rotates relative to the fixed plate and drives a display screen to move to one side horizontally.

The mounting panel is disposed on the skeleton and installed in a region exposed after a display screen is moved, and the mounting panel is provided with an electrical element.

Based on the above solution, preferably, the lateral sides of the adjacent display screens are in contact with each other. One side of the display screen is provided with a trim strip, and the trim strip is a bending plate. A bending part on one side of the trim strip is fixedly connected to the display screen, and a bending part on the other side of the trim strip is wrapped on a lateral side of an adjacent display screen.

Based on the above solution, preferably, the skeleton has a frame structure, and a radiator is disposed in the skeleton. Each of the upper side and the lower side of the skeleton is provided with a heat dissipation plate, and the heat dissipation plate is provided with heat dissipation holes.

Based on the above solution, preferably, hooks are fixed to both sides of the fixed plate, and the hooks are hung on a cross beam of the skeleton and are fixedly connected through bolts. The connecting plate is provided with a connecting hole, and a cross-section of the connecting hole is a circle whose diameter gradually decreases from top to bottom. A cylindrical fixed block is disposed at a connection position between the rear surface of the display screen and the connecting plate. The diameter of a circular cross-section of the fixed block is greater than the diameter of a circle at the bottom of the connecting hole and less than the diameter of a circle at the top of the connecting hole. A clamping groove is disposed in the middle of the fixed block and is clamped with the connecting hole.

Based on the above solution, preferably, the connecting plate is provided with heat dissipation holes.

Based on the above solution, preferably, the skeleton is fixedly connected to a suspension beam and is suspended through the suspension beam.

The present disclosure has the following beneficial effects:
1. By using the hanger, the display screen can horizontally slide to one side relative to the skeleton, which greatly reduces the space volume occupied by the display screen when the display screen is opened and makes it convenient to open and close the display screen, thus reducing the difficulty in performing high-altitude operations by maintenance workers.
2. Electrical elements inside the display screen are centrally installed in the region exposed after the display screen slides, which makes it convenient to maintain and replace devices. In addition, there is large space between the display screen and the skeleton after the display screen is opened, which gives sufficient space required by the workers to complete construction of the display.
3. The display screen is detachably connected to the skeleton through the hanger, which realizes a simple structure and convenient assembly and disassembly, and is convenient for high-altitude operations.
4. The display screens are disposed in a wraparound manner to improve the effectiveness of the display screen to advertise while saving floor space.
5. The skeleton adopts the frame structure, which effectively reduces weight and saves production costs. The radiator can be disposed in the skeleton to perform effective heat dissipation on the display screen.
6. The multi-panel wraparound stereoscopic display can be installed in an embedded manner or a suspended manner. Therefore, the multi-panel wraparound stereoscopic display can be widely applied and is suitable for different installation places and spaces.

### BRIEF DESCRIPTION OF THE DRAWINGS

FIG. 1 is a schematic structural diagram of a multi-panel wraparound stereoscopic display in an expanded state according to the present disclosure;
FIG. 2 is a top view of a multi-panel wraparound stereoscopic display in an expanded state (excluding a heat dissipation plate on the top) according to the present disclosure;
FIG. 3 is a schematic structural diagram of a multi-panel wraparound stereoscopic display in a use state according to the present disclosure;
FIG. 4 is a schematic structural diagram of a skeleton according to the present disclosure;
FIG. 5 is a schematic diagram of the connection between the display screen and the hanger according to the present disclosure; and
FIG. 6 is a schematic diagram of a hanger according to the present disclosure.

### DETAILED DESCRIPTION OF THE EMBODIMENTS

The present disclosure will be further described in detail below in conjunction with the accompanying drawings and embodiments.

In the present disclosure, unless otherwise specified and defined, the terms "installation", "interconnection," "connection," and "fixation" are intended to be understood in a broad sense. For example, the connection may be a fixed connection, a removable connection, or an integral connection. The connection may be a direct connection or an indirect connection using an intermediate medium. The connection may be a communication or interaction between two elements. Those of ordinary skill in the art may understand that the above terms may have specific meanings based on a specific situation.

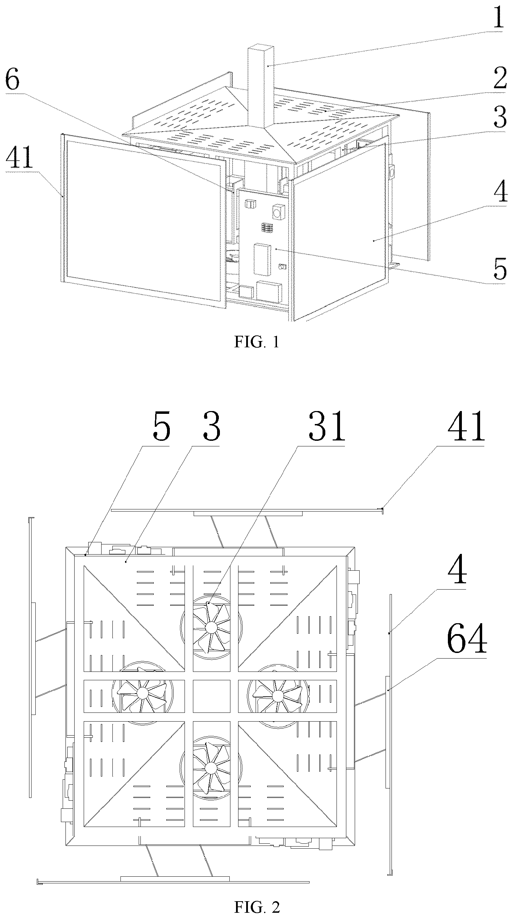

It should be understood that in the description of the present disclosure, terms such as "center", "length", "upper", "lower", "front", "rear", "left", "right", "vertical", "horizontal", "top", "bottom", and "inside" indicate the orientation or positional relationships based on FIG. 1. They are merely intended to facilitate and simplify the description of the present disclosure, rather than to indicate or imply that the mentioned apparatuses or components must have a specific orientation or must be constructed and operated in a specific orientation. Therefore, these terms should not be construed as a limitation to the present disclosure. Moreover, the terms such as "first" and "second" are used only for the purpose of description and should not be construed as indicating or implying a relative importance or implicitly indicating a quantity of indicated technical features. Thus, features defined with "first" and "second" may explicitly or implicitly include one or more of the features. In the description of the present disclosure, unless otherwise specified, "a plurality of" means at least two.

In the present disclosure, unless otherwise expressly specified and defined, a first feature being "above" or "under" a second feature may include the first feature being in direct contact with the second feature, or the first feature and the second feature not being in direct contact with each other but being in contact by using another feature between them. In addition, the first feature being "over", "above", and "on" the second feature includes the first feature being directly above and diagonally above the second feature, or simply indicates that the horizontal height of the first feature is greater than that of the second feature. The description of the first feature as "under", "below", and "underneath" the second feature includes the first feature being directly under or obliquely under the second feature, or simply indicates that the horizontal height of the first feature is less than that of the second feature.

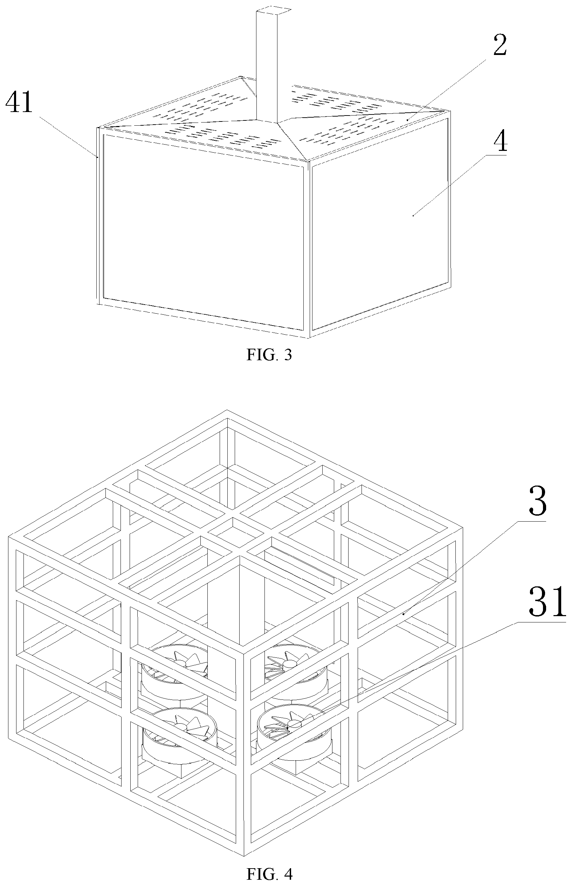

As shown in FIG. 1 to FIG. 6, a multi-panel wraparound stereoscopic display includes a skeleton 3, a display screen 4, a mounting panel 5, and a hanger 6. At least three display screens 4 are detachably installed on the skeleton 3 through the hanger 6. Multiple display screens 4 are rotatably symmetrically distributed along an axis of symmetry, and the display screens 4 are disposed in parallel with the axis of symmetry. The display screens disposed in a wraparound manner can fully save floor space and improve the effectiveness of advertisement. In this embodiment, for example, there are four display screens.

As shown in FIG. 2, in order to optimize a display effect, the lateral sides of the adjacent display screens 4 are in contact with each other. One side of the display screen 4 is provided with a trim strip 41, and the trim strip 41 is a bending plate. A bending part on one side of the trim strip 41 is fixedly connected to the display screen 4, and a bending part on the other side of the trim strip 41 is wrapped on a side of an adjacent display screen 4. The trim strip 41 can effectively hide a gap between the adjacent display screens, which can play a role in the beautification of the display screens and prevent foreign matters such as dust from entering the gap.

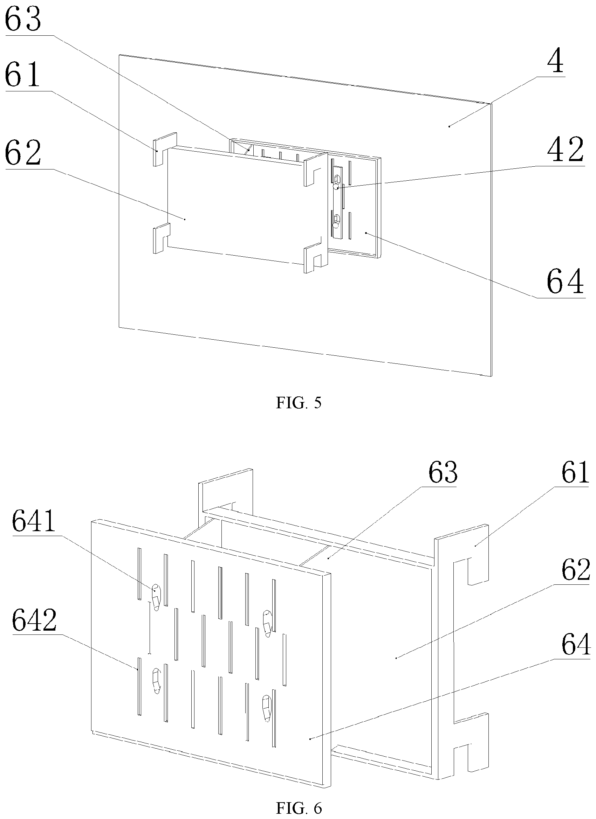

As shown in FIG. 5 and FIG. 6, the hanger 6 includes a fixed plate 62, a rotating plate 63, and a connecting plate 64. The display screen 4 is detachably installed on the connecting plate 64. The fixed plate 62 is detachably installed on the skeleton 3. The fixed plate 62 and the connecting plate 64 are respectively hinged to both ends of the rotating plate 63 to form a double rocker mechanism. The rotating plate 63 rotates relative to the fixed plate 62 and drives the display screen 4 to move to one side horizontally. After opening a lock at the bottom of the display screen 4, an operator disconnects the display screen 4 away from the skeleton 3 and moves the display screen 4 to one side horizontally, which can open the display screen, reduce the floor space required for opening the display screen, and facilitate opening and closing of the display screen.

Preferably, the hooks 61 are fixed to both sides of the fixed plate 62. The hooks 61 are hung on the skeleton 3 and are fixedly connected through bolts. The connecting plate 64 is provided with a connecting hole 641, and a cross-section of the connecting hole 641 is a circle whose diameter gradually decreases from top to bottom. A cylindrical fixed block 42 is disposed at a connection position between the rear surface of the display screen 4 and the connecting plate 64, and the diameter of a circular cross-section of the fixed block 42 is greater than the diameter of a circle at the bottom of the connecting hole 641 and less than a diameter of a circle at the top of the connecting hole 641. A clamping groove is disposed in the middle of the fixed block 42 and is clamped with the connecting hole 641. In order to facilitate timely heat dissipation of the display screen 4, a plurality of heat dissipation holes 642 are disposed on the connecting plate 64. The above structure can realize a detachable connection between the display screen and the skeleton, which realizes a simple structure and convenient assembling and disassembling and reduces the difficulty in performing high-altitude operations by workers.

The skeleton 3 is provided with the mounting panel 5, which is disposed in a region exposed after the display screen 4 is moved. Electrical elements required by the display are centrally installed on the mounting panel 5. The electrical elements include a power supply, a computer, a filter, a leakage protector, a wiring terminal, a potentiometer, a monitoring board, and the like, such that the workers can carry out centralized maintenance and replacement after moving the display screen 4. Moreover, since the display screen 4 moves outward relative to the skeleton 3 while sliding horizontally, sufficient maintenance space can be reserved.

The skeleton 3 has a frame structure, which can effectively reduce weight and save production costs. Since the display screen 4 is disposed in the wraparound manner, in order to perform heat dissipation on the display screen 4 in time, a radiator 31 is disposed in the skeleton 3, and each of the upper side and the lower side of the skeleton 3 is provided with a heat dissipation plate 2. The heat dissipation plate 2 is provided with heat dissipation holes. The radiator 31 receives low-temperature air from lower heat dissipation holes and discharges hot air from upper cooling holes to achieve a good heat dissipation effect. In order to meet the needs of different installation environments, the suspension beam 1 can be fixedly connected to the skeleton 3 to suspend the multi-panel wraparound stereoscopic display.

The present disclosure is described above by way of example, but the present disclosure is not limited to the above specific embodiments. Any modification or variation based on the present disclosure falls within the protection scope of the appended claims.

## Claims

1. A multi-panel wraparound stereoscopic display, **characterized by** comprising a skeleton (3), a display screen (4), a mounting panel (5), and a hanger (6), wherein
at least three display screens (4) are detachably installed on the skeleton (3) through as many hangers (6) as there are screens, multiple display screens (4) are rotatably symmetrically distributed along an axis of symmetry, and the display screens (4) are disposed in parallel with the axis of symmetry;
every hanger (6) comprises a fixed plate (62), a rotating plate (63), and a connecting plate (64), wherein a display screen (4) is detachably installed on the connecting plate (64), the fixed plate (62) is detachably installed on the skeleton (3), the fixed plate (62) and the connecting plate (64) are respectively hinged to both ends of the rotating plate (63) to form a double rocker mechanism, and the rotating plate (63) rotates relative to the fixed plate (62) and drives a display screen (4) to move to one side horizontally; and
the mounting panel (5) is disposed on the skeleton (3) and installed in a region exposed after a display screen (4) is moved, and the mounting panel (5) is provided with an electrical element.

2. The multi-panel wraparound stereoscopic display according to claim 1, **characterized in that** lateral sides of the adjacent display screens (4) are in contact with each other, one side of the display screen (4) is provided with a trim strip (41), the trim strip (41) is a bending plate, a bending part on one side of the trim strip (41) is fixedly connected to the display screen (4), and a bending part on the other side of the trim strip (41) is wrapped on a lateral side of an adjacent display screen (4).

3. The multi-panel wraparound stereoscopic display according to claim 1, **characterized in that** the skeleton (3) has a frame structure, a radiator (31) is disposed in the skeleton (3), each of an upper side and a lower side of the skeleton (3) is provided with a heat dissipation plate (2), and the heat dissipation plate (2) is provided with heat dissipation holes.

4. The multi-panel wraparound stereoscopic display according to claim 1, **characterized in that** hooks (61) are fixed to both sides of the fixed plate (62), and the hooks (61) are hung on a cross beam of the skeleton (3) and are fixedly connected through bolts; the connecting plate (64) is provided with a connecting hole (641), and a cross section of the connecting hole (641) is a circle whose diameter gradually decreases from top to bottom; a cylindrical fixed block (42) is disposed at a connection position between a rear surface of the display screen (4) and the connecting plate (64), and a diameter of a circular cross section of the fixed block (42) is greater than a diameter of a circle at a bottom of the connecting hole (641) and less than a diameter of a circle at a top of the connecting hole (641); and a clamping groove is disposed in a middle of the fixed block (42), and is clamped with the connecting hole (641).

5. The multi-panel wraparound stereoscopic display according to claim 1, **characterized in that** the connecting plate (64) is provided with heat dissipation holes (642).

6. The multi-panel wraparound stereoscopic display according to claim 1, **characterized in that** the skeleton (3) is fixedly connected to a suspension beam (1) and is suspended through the suspension beam (1).

## Patentansprüche

1. Umgebende stereoskopische Mehrfeldanzeige, **gekennzeichnet durch** ein Skelett (3), einen Anzeigebildschirm (4), ein Montagefeld (5) und einen Hängebock (6), wobei
wenigstens drei Anzeigebildschirme (4) durch Hängeböcke (6) in gleicher Anzahl wie Bildschirme lösbar an dem Skelett (3) angebracht sind, mehrere Anzeigebildschirme (4) drehsymmetrisch entlang einer Symmetrieachse verteilt sind und die Anzeigebildschirme (4) parallel zur Symmetrieachse angeordnet sind;
jeder Hängebock (6) eine feste Platte (62), eine rotierende Platte (63) und eine Verbindungsplatte (64) umfasst, wobei ein Anzeigebildschirm (4) lösbar an der Verbindungsplatte (64) installiert ist, die fixierte Platte (62) lösbar an dem Skelett (3) installiert ist, die fixierte Platte (62) und die Verbindungsplatte (64) an beiden Enden der rotierenden Platte (63) drehbar angebracht sind, um einen Doppelkippmechanismus zu bilden, und die rotierende Platte (63) sich relativ zu der fixierten Platte (62) dreht und einen Anzeigebildschirm (4) horizontal zu einer Seite bewegt; und
das Montagefeld (5) an dem Skelett (3) angeordnet und in einem Bereich installiert ist, der nach dem Bewegen des Anzeigebildschirms (4) freiliegt, wobei das Montagefeld (5) mit einem elektrischen Element versehen ist.

2. Umgebende stereoskopische Mehrfeldanzeige nach Anspruch 1, **dadurch gekennzeichnet, dass** die lateralen Seiten benachbarter Anzeigebildschirme (4) miteinander in Kontakt stehen, eine Seite des Anzeigebildschirms (4) mit einem Verkleidungsstreifen (41) versehen ist, wobei der Verkleidungsstreifen (41) eine Biegeplatte ist, ein Biegeteil auf einer Seite des Verkleidungsstreifens (41) fest mit dem Anzeigebildschirm (4) verbunden ist und ein Biegeteil auf der anderen Seite des Verkleidungsstreifens (41) um eine laterale Seite eines benachbarten Anzeigebildschirms (4) gewickelt ist.

3. Umgebende stereoskopische Mehrfeldanzeige nach Anspruch 1, **dadurch gekennzeichnet, dass** das Skelett (3) eine Rahmenstruktur aufweist, ein Kühler (31) in dem Skelett (3) angeordnet ist, eine obere Seite und eine untere Seite des Skeletts (3) jeweils mit einer Wärmeableitungsplatte (2) versehen sind und die Wärmeableitungsplatte (2) mit Wärmeableitungslöchern versehen ist.

4. Umgebende stereoskopische Mehrfeldanzeige nach Anspruch 1, **dadurch gekennzeichnet, dass** Haken (61) an beiden Seiten der fixierten Platte (62) fixiert sind und die Haken (61) an einem Querträger des Skeletts (3) aufgehängt und durch Bolzen fest verbunden sind; wobei die Verbindungsplatte mit einem Verbindungsloch (641) versehen ist und ein Querschnitt des Verbindungslochs (641) ein Kreis ist, dessen Durchmesser von oben nach unten allmählich abnimmt; wobei ein zylindrischer fixierter Block (42) an einer Verbindungsposition zylindrisch einer Rückseitenfläche des Anzeigebildschirms (4) und der Verbindungsplatte (64) angeordnet ist und ein Durchmesser eines kreisförmigen Querschnitts des fixierten Blocks (42) größer als ein Durchmesser eines Kreises an einer Unterseite des Verbindungslochs (641) und kleiner als ein Durchmesser eines Kreises an einer Oberseite des Verbindungslochs (641) ist; und eine Klemmnut in einer Mitte des fixierten Blocks (42) angeordnet und mit dem Verbindungsloch (641) zusammengeklemmt ist.

5. Umgebende stereoskopische Mehrfeldanzeige nach Anspruch 1, **dadurch gekennzeichnet, dass** die Verbindungsplatte (64) mit Wärmeableitungslöchern (642) versehen ist.

6. Umgebende stereoskopische Mehrfeldanzeige nach Anspruch 1, **dadurch gekennzeichnet, dass** das Skelett (3) fest mit einem Aufhängungsbalken (1) verbunden und durch den Aufhängungsbalken (1) aufgehängt ist.

## Revendications

1. Un affichage stéréoscopique à multiples panneaux enveloppants, **caractérisé en ce qu'**il comprend un squelette (3), un écran d'affichage (4), un panneau de montage (5), et une suspente (6), dans lequel
au moins trois écrans d'affichage (4) sont installés de façon amovible sur le squelette (3) via autant de suspentes (6) qu'il y a d'écrans, les multiples écrans d'affichage (4) sont répartis symétriquement de façon rotative le long d'un axe de symétrie, et les écrans d'affichage (4) sont placés en parallèle à l'axe de symétrie ;
chaque suspente (6) comprend une plaque fixe (62), une plaque rotative (63), et une plaque de raccordement (64), dans lesquelles un écran d'affichage (4) est installé de façon amovible sur la plaque de raccordement (64), la plaque fixe (62) est installée de façon amovible sur le squelette (3), la plaque fixe (62) et la plaque de raccordement (64) sont respectivement articulées aux deux terminaisons de la plaque rotative (63) pour former un double mécanisme à bascule, et la plaque rotative (63) pivote par rapport à la plaque fixe (62) et entraîne le déplacement horizontal d'un écran d'affichage (4) sur un côté ; et
le panneau de montage (5) est placé sur le squelette (3) et installé dans une région exposée une fois que l'écran d'affichage (4) est déplacé, et le panneau de montage (5) est muni d'un élément électrique.

2. Un affichage stéréoscopique à multiples panneaux enveloppants selon la revendication 1, **caractérisé en ce que** les côtés latéraux d'écrans d'affichage adjacents (4) sont en contact mutuel, un côté de l'écran d'affichage (4) est muni d'une bande décorative (41), la bande décorative (41) étant une plaque de cintrage, une partie de cintrage sur un côté de la bande décorative (41) est raccordée fixement à l'écran d'affichage (4), et une partie de cintrage sur l'autre côté de la bande décorative (41) est enveloppée sur un côté latéral de l'écran d'affichage adjacent (4).

3. Un affichage stéréoscopique à multiples panneaux enveloppants selon la revendication 1, **caractérisé en ce que** le squelette (3) est doté d'une structure de châssis, un radiateur (31) est placé dans le squelette (3), un côté supérieur et un côté inférieur du squelette (3) sont chacun munis d'une plaque de dissipation de chaleur (2), et la plaque de dissipation de chaleur (2) est munie de trous de dissipation de chaleur.

4. Un affichage stéréoscopique à multiples panneaux enveloppants selon la revendication 1, **caractérisé en ce que** des crochets (61) sont fixés sur les deux côtés de la plaque fixe (62), et les crochets (61) sont suspendus sur une traverse du squelette (3) et sont raccordés fixement via des boulons ; la plaque de raccordement (64) est munie d'un trou de raccordement (641), et une section transversale du trou de raccordement (641) est un cercle dont le diamètre décroît graduellement du haut vers le bas ; un bloc cylindrique fixe (42) est placé à une position de raccordement entre la surface arrière de l'écran d'affichage (4) et la plaque de raccordement (64), et le diamètre de la section transversale circulaire du bloc cylindrique fixe (42) est supérieur au diamètre du cercle à la base du trou de raccordement (641) et est inférieur au diamètre du cercle au sommet du trou de raccordement (641) ; et une gorge de serrage est placée au milieu du bloc fixe (42), et est serrée par le trou de raccordement (641).

5. Un affichage stéréoscopique à multiples panneaux enveloppants selon la revendication 1, **caractérisé en ce que** la plaque de raccordement (64) est munie de trous de dissipation de chaleur (642).

6. Un affichage stéréoscopique à multiples panneaux enveloppants selon la revendication 1, **caractérisé en ce que** le squelette (3) est raccordé fixement à une poutre de suspension (1) et est suspendu via la poutre de suspension (1).
